# EUROPEAN PATENT SPECIFICATION

(11) **EP 4 464 656 B1**
(45) Date of publication and mention of the grant of the patent: **19.08.2026**
(21) Application number: 24174388.9
(22) Date of filing: 06.05.2024
(51) Int. Cl.: B81B 3/00, B81C 1/00

(54) **MEMS DEVICE AND FABRICATION PROCESS WITH REDUCED Z-AXIS STICTION**
MEMS-VORRICHTUNG UND HERSTELLUNGSVERFAHREN MIT REDUZIERTER Z-ACHSEN-HAFTKRAFT
DISPOSITIF MEMS ET PROCÉDÉ DE FABRICATION AVEC FROTTEMENT AU POINT D'AXE Z RÉDUIT

(30) Priority: 09.05.2023 US 202318195317
(43) Date of publication of application: 20.11.2024
(73) Proprietor: STMicroelectronics International N.V., 1228 Plan-les-Ouates, Geneva (CH)
(72) Inventor: Liu, Lianjun, 5656AG Eindhoven (NL); McKillop, John Slaton, 5656AG Eindhoven (NL)
(74) Representative: Studio Torta S.p.A.

(56) References cited:
- US-A1- 2006 144 816
- US-A1- 2012 060 607
- US-A1- 2017 313 573

## Description

### BACKGROUND

### Technical field

The present disclosure is directed in general to the field of semiconductor devices. In one aspect, the present disclosure relates to MEMS devices and methods for fabricating MEMS devices.

### Description of the Related Art

Micro-Electro-Mechanical Systems (MEMS) technology is increasingly used to integrate mechanical elements, sensors, actuators, and electronics on a common silicon substrate through microfabrication technology. For example, inertial sensors may be formed with MEMS devices on an integrated circuit wafer substrate to form various applications, such accelerometers for measuring linear acceleration, gyroscopes for measuring angular velocity, optical devices, pressure sensors, switches, and so forth. A conventional MEMS device typically includes a moveable element, such as a proof mass, diaphragm, mirror, and the like that is flexible or movable, and is attached to the rest of the device. Relative motion between this movable element and the rest of the device is driven by actuators and/or sensed by sensors in various ways, depending on device design. With existing semiconductor processing techniques, it has been observed that Z-axis accelerometer devices are more prone to stiction. One of the reasons for this is that there is a higher likelihood of stiction between the very smooth contact surface of the single crystal silicon proof mass and the very smooth contact surface of the polysilicon electrode surface. While anti-stiction coatings have been proposed for use with forming accelerometer sensors, such coatings can interfere with the eutectic bonding process used to form gyrometer sensors. As a result, the existing design, operation, and manufacturability of integrated circuit MEMS sensors are extremely difficult to implement at a practical level.

US 2012/060607 A1 describes a solution for avoiding stiction in a MEMS sensor where the surface of the moving part which may come into contact with a fixed electrode is given asperities or a scalloped form. This surface roughness is the typical result of the "Bosch process" used to make high aspect ratio features by deep reactive ion etching (DRIE).

### SUMMARY

A MEMS sensor device according to the invention is defined in claim 1.

A method of fabricating a transducer according to the invention is defined in claim 9.

In the remainder of this description all embodiments described are examples of devices or methods which are useful for understanding the invention. If an embodiment is according to the invention this is specifically stated.

In accordance with a first aspect of the present disclosure, a MEMS sensor device is provided, comprising: a first inertial transducer element formed in a multi-layer semiconductor structure; and a cap device bonded to the multi-layer semiconductor structure to protect the first inertial transducer element from ambient environmental conditions, where the first inertial transducer element comprises a first monocrystalline semiconductor proof mass element and a second conductive electrode element separated from one another by an air sensing gap, and where at least a first sensing gap surface of the first monocrystalline semiconductor proof mass element is a first rough surface that has been selectively etched to reduce stiction between the first monocrystalline semiconductor proof mass element and the second conductive electrode element.

In one or more embodiments, at least a second sensing gap surface of the second conductive electrode element is a second rough surface that has been selectively etched to reduce stiction between the first monocrystalline semiconductor proof mass element and the second conductive electrode element.

In one or more embodiments, the first inertial transducer element comprises a z-axis accelerometer sensor.

In one or more embodiments, the first monocrystalline semiconductor proof mass element comprises a cantilevered monocrystalline silicon beam anchored to the multi-layer semiconductor structure.

In one or more embodiments, the second conductive electrode element comprises a conductive polysilicon layer formed in the multi-layer semiconductor structure to be positioned in alignment with but separated from the cantilevered monocrystalline silicon beam.

In one or more embodiments, the cap device is bonded to the multi-layer semiconductor structure with a high temperature eutectic seal ring bonding structure to form a vacuum in a first sensor cavity which houses the first inertial transducer element.

In one or more embodiments, at least the first sensing gap surface of the first monocrystalline semiconductor proof mass element includes a non-uniform layer of deposited polymer that has been selectively etched to form the first rough surface.

In one or more embodiments, at least the second sensing gap surface of the second conductive electrode element includes a non-uniform layer of deposited polymer that has been selectively etched to form the second rough surface.

In accordance with a second aspect of the present disclosure, a method for fabricating a transducer is conceived, comprising: providing a MEMS wafer structure comprising a first semiconductor electrode and a first semiconductor layer that is formed over the first semiconductor electrode; selectively etching the first semiconductor layer to form a first MEMS inertial transducer element and surrounding frame support elements; applying a structural release etch process to release the first MEMS inertial transducer element and to expose a first sensing gap surface of the first MEMS inertial transducer element and a second sensing gap surface of the first semiconductor electrode; applying a surface abrasion etch process to roughen one or both of the first sensing gap surface of the first MEMS inertial transducer element or the second sensing gap surface of the first semiconductor electrode, thereby reducing stiction between the first MEMS inertial transducer element and the first semiconductor electrode; and attaching a first cap wafer structure to the MEMS wafer structure using a first bonding process.

In one or more embodiments, providing the MEMS wafer structure comprises forming the first semiconductor electrode as a polycrystalline silicon electrode over which the first semiconductor layer is formed as a first monocrystalline semiconductor layer.

In one or more embodiments, providing the MEMS wafer structure comprises forming the first semiconductor electrode as a polycrystalline silicon electrode over which the first semiconductor layer is formed as a first polycrystalline semiconductor layer.

In one or more embodiments, selectively etching the first semiconductor layer comprises etching the first semiconductor layer with a deep reactive ion etch process to form the first MEMS inertial transducer element as a high aspect ratio proof mass transducer element.

In one or more embodiments, the high aspect ratio proof mass transducer element comprises a z-axis accelerometer sensor.

In one or more embodiments, applying the structural release etch process comprises applying a vapor release etch to remove a sacrificial dielectric layer formed between the semiconductor electrode and the first semiconductor layer.

In one or more embodiments, applying the surface abrasion etch process comprises applying a non-homogeneous plasma etch which etches crystalline grain boundary regions in either or both of the first MEMS inertial transducer element or the first semiconductor electrode faster than non-boundary regions in either or both of the first MEMS inertial transducer element or the first semiconductor electrode.

In one or more embodiments, applying the surface abrasion etch process comprises: depositing a non-uniform polymer layer on at least the first and second sensing gap surfaces; and applying a semiconductor etch process which roughens the first and second sensing gap surfaces by selectively etching the first MEMS inertial transducer element and the first semiconductor electrode not protected by the non-uniform polymer layer.

**In** one or more embodiments, attaching the first cap wafer structure to the MEMS wafer structure comprises bonding the first cap wafer structure to the MEMS wafer structure with a high temperature eutectic seal ring bonding structure to form a vacuum in a first sensor cavity of the cap wafer structure which houses the first MEMS inertial transducer element.

**In** accordance with a third aspect of the present disclosure, a high aspect ratio transducer is provided, comprising: a first cap structure comprising a substrate, a plurality of first metal interconnect bond spacer structures, and a high vacuum cavity formed in the substrate to define a first inertial transducer space; a first semiconductor substrate structure attached to the plurality of first metal interconnect bond spacer structures, the first semiconductor substrate structure comprising: a first surface on which a second patterned metallic layer is formed and bonded to the plurality of first metal interconnect bond spacer structures, a first high aspect ratio proof mass element which is aligned with the first inertial transducer space, and a second surface on which a plurality of spacer structures are formed to define an out-of-plane semiconductor sensing electrode space; and a second semiconductor substrate structure attached to the plurality of spacer structures and comprising an out-of-plane semiconductor sensing electrode which is aligned with the first high aspect ratio proof mass element, where at least a first sensing gap surface of the first high aspect ratio proof mass element is a first rough surface that has been selectively etched to reduce stiction between the first high aspect ratio proof mass element and the out-of-plane semiconductor sensing electrode.

In one or more embodiments, the first high aspect ratio proof mass element comprises a cantilevered monocrystalline silicon beam anchored to the first semiconductor substrate structure, where the out-of-plane semiconductor sensing electrode comprises a polycrystalline silicon electrode layer formed in the second semiconductor substrate structure.

In one or more embodiments, at least second sensing gap surface of the out-of-plane semiconductor sensing electrode is a second rough surface that has been selectively etched to reduce stiction between the first high aspect ratio proof mass element and the out-of-plane semiconductor sensing electrode.

### BRIEF DESCRIPTION OF THE DRAWINGS

The present disclosure may be understood, and its numerous objects, features and advantages obtained, when the following detailed description of a preferred embodiment is considered in conjunction with the following drawings.
Figure 1 is a simplified cross section view of a MEMS sensor device which includes MEMS transducer elements with reduced Z-axis stiction in accordance with selected embodiments of the present disclosure.
Figures 2-9 are simplified cross section views of various exemplary fabrication steps for making the MEMS sensor device shown in Figure 1 in accordance with selected embodiments of the present disclosure.
Figure 10 depicts a simplified flow chart showing the processing steps for fabricating a MEMS sensor device with reduced Z-axis stiction in accordance with selected embodiments of the present disclosure.

### DETAILED DESCRIPTION

A method and apparatus are described for fabricating high aspect ratio transducers (i.e., an "inertial transducer element") in a MEMS device wafer assembly by applying one or more non-homogeneous etch and/or deposition process step(s) to roughen at least one of the contact surfaces of the single crystal silicon proof mass and/or the polysilicon electrode, thereby reducing Z-axis stiction for the MEMS device. By creating at least one rough surface, the effective contact area when the proof-mass touches the bottom electrode is significantly reduced, thereby reducing the adhesion force and contact stiction. In selected embodiments, a MEMS device wafer having a deposited polycrystalline electrode layer and a monocrystalline substrate or proof mass layer is subjected to a first patterned transducer etch process of the monocrystalline substrate or proof mass layer to form one or more monocrystalline proof mass elements, including a movable sensor proof mass used for a MEMS sensor (e.g., a gyroscope sensor mass), and is then subjected to a non-homogeneous etch step that non-uniformly etches the surface of the monocrystalline proof mass element(s) and the polysilicon electrode layer. By choosing a non-homogeneous etch process which etches the grain boundaries and nearby areas of the polysilicon electrode layer faster than the rest of the polysilicon electrode layer, valleys are created in the grain boundary areas and peaks are created in the non-boundary regions. As a result, the surface roughness of polysilicon electrode layer is increased. In other selected embodiments, a MEMS device wafer with one or more patterned monocrystalline proof mass elements is subjected to a very thin and non-uniform polymer deposition step and a subsequent silicon etch step. By depositing a suitable non-uniform polymer, the subsequent silicon etching step will non-uniformly etch the patterned monocrystalline proof mass elements, resulting in peaks and valleys in the patterned monocrystalline proof mass element(s). This method can increase the surface roughness in both the single crystal silicon surface of the patterned monocrystalline proof mass element(s) and the polysilicon electrode layer. As will be appreciated, additional processing may be used to form one or more sensor electrodes, driver electrodes, and/or interconnect routing in the MEMS device.

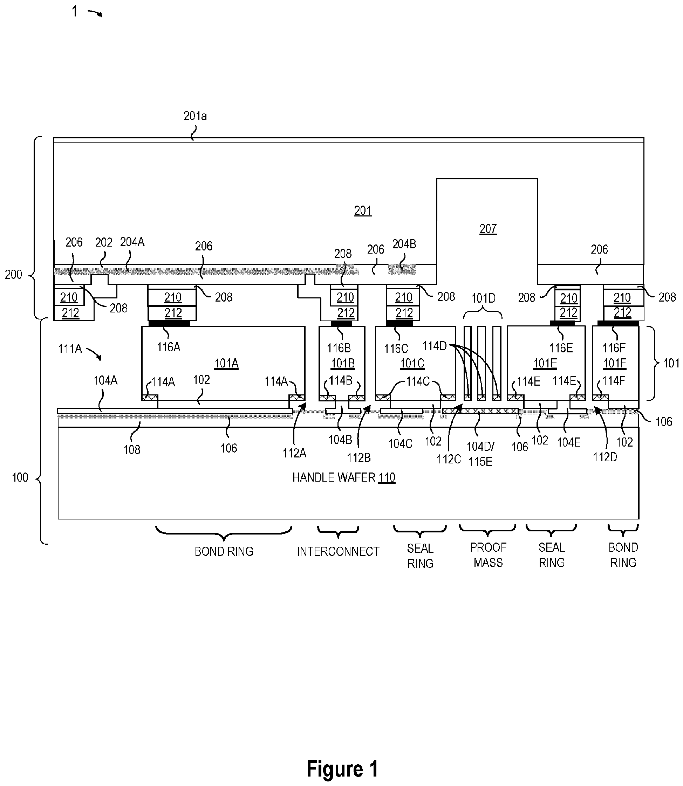

Referring now to Figure 1, there is shown a simplified cross section view of a MEMS sensor device wafer assembly 1 that includes a cap wafer structure (i.e., a "cap device") 200 attached or affixed to a MEMS wafer device 100 which includes one or more of MEMS transducer sensor elements (i.e., "MEMS inertial elements") that are formed in a multi-layer semiconductor structure with reduced Z-axis stiction in accordance with selected embodiments of the present disclosure. Generally speaking, the MEMS wafer device 100 is formed on a monocrystalline semiconductor membrane wafer substrate 101 (i.e., "first substrate") by selectively forming anchor elements 102/104A-E/106, which include deposited polysilicon layers 104D (i.e., a poly sense electrode layer 104D) on the monocrystalline membrane wafer substrate 101, along with a planarized dielectric layer 108 and patterned bond anchor elements 116. At exposed sensing gap surfaces 114A-F (i.e., "first sensing gap surface") at the monocrystalline proof mass elements 101D (i.e., "first monocrystalline semiconductor proof mass elements") and a poly sense electrode layer 104D/115E (i.e., "second conductive electrode element"), abraded or rough surface layers are formed (referred to collectively as abraded or roughed surface layers 114). In addition, the cap wafer structure 200 (i.e., "cap device") is formed on a monocrystalline semiconductor wafer 201 by selectively forming defined insulator layers 202, 206 and patterned conductor layers 204, selectively etching the monocrystalline semiconductor wafer 201 to form an etched cap cavity 207, and then selectively forming metal bond anchor elements 208/210/212.

In the depicted MEMS wafer device 100, the MEMS transducer sensor element may be a gyro sensor formed with a high aspect ratio monocrystalline semiconductor proof mass element monocrystalline 101D with abraded surfaces 114D (i.e., "first rough surfaces") and one or more out-of-plane polycrystalline sensing electrodes 104D/115E that are integrated with the MEMS wafer device 100 that is attached or bonded to a cap wafer structure 200 using metal compression bonding techniques. As used herein, and in some embodiments, an "abraded" or "roughed surface" means a surface having a roughness average (RA) of between about 150 angstroms and about 500 angstroms. In other embodiments, a roughed or abraded surface may have an RA between about 100 and about 1,000 angstroms, although other higher or lower RA values may be used. In addition or in the alternative, an "abraded" or "roughed surface" may refer to a polycrystalline semiconductor layer having peaks and/or valleys formed on the surface of the polycrystalline semiconductor layer, such as etched or recessed valleys at the poly grain boundaries and nearby areas and/or peaks at the non-boundary surface areas. In addition or in the alternative, an "abraded" or "roughed surface" may refer to a monocrystalline semiconductor layer having peaks and valleys on the surface of the monocrystalline semiconductor layer that are formed by depositing a non-uniform polymer layer on the surface of the monocrystalline semiconductor layer, followed by an etch process which removes the non-uniform polymer layer to form the peaks and valleys on the surface of the monocrystalline semiconductor layer. As will be appreciated, the MEMS transducer sensor element can represent any type of MEMS sensor (such as an accelerometer, a gyroscope, etc.), and any number of MEMS sensor devices could be formed in either or both of the MEMS wafer device 100 and cap wafer structure 200.

As formed, the MEMS transducer sensor element may include a monocrystalline semiconductor proof mass element 101D that is formed under a high vacuum cavity 207 in the cap wafer structure 200 and suspended within the monocrystalline semiconductor membrane wafer substrate 101 by, for example, one or more suspension springs (not shown). In other embodiments, the monocrystalline semiconductor proof mass element 101D may be formed as a cantilevered monocrystalline silicon beam anchored to a multi-layer semiconductor structure. As disclosed herein and indicated with the cross-hatching, roughened or abraded surfaces 114A-F are formed on at least the monocrystalline MEMS proof mass 101D (if not also the one or more structural connection elements 101A-C, 101E-F) by applying one or more non-homogeneous etch and/or deposition process step(s). The MEMS transducer sensor element may also include one or more polycrystalline sensing electrodes 104D/115E which are positioned to detect vibrational movement of the monocrystalline MEMS proof mass 101D/114D. In addition, the MEMS transducer sensor element includes one or more structural connection elements 100A-C, 101E-F formed in the monocrystalline semiconductor membrane wafer layer 101 which are fixedly coupled to the cap wafer structure 200 (by the metal bond anchor elements 208/210/212/116) and to the monocrystalline handle wafer substrate layer 110 (by the bond anchor elements 102/104/106/108). In addition to serving as a mechanical anchor of the proof mass 101D/114D to the surrounding frame, the structural connection elements (e.g., 101C, 101E) may also function as a seal ring structure to provide a vacuum seal for the high vacuum cavity 207 when the first MEMS wafer device 100 and first cap wafer structure 200 are bonded together, such as by using a eutectic bonding process. In addition or in the alternative, the structural connection elements (e.g., 101A, 101F) may also function as bond ring structures which are formed to fixedly couple the first MEMS wafer device 100 to the first cap wafer structure 200 across metal bond anchor elements 208/210/212/116) and to the monocrystalline handle wafer substrate layer 110 (by the bond anchor elements 106/104/102). In addition or in the alternative, the structural connection elements (e.g., 101B, 101E) may also function as electrical interconnect structures which provide an electrical connection between one part of the circuit in the first MEMS wafer device 100 and another circuit in the first cap wafer structure 200.

Though shown in simplified cross section view, it will be appreciated that the MEMS sensor device wafer assembly 1 may also include one or more non-illustrated moving electrodes and one or more non-illustrated fixed electrodes. The moving electrodes may form part of the suspended sensor structures 101D/114D, and the fixed electrodes may be fixedly coupled to the monocrystalline membrane wafer layer 101 and/or monocrystalline handle wafer layer 110. The specific structure and configuration of the MEMS sensor may vary. Moreover, a description of the specific structure and configuration of the MEMS sensor is not needed to enable or fully describe the present disclosure, and will thus not be further described in more detail.

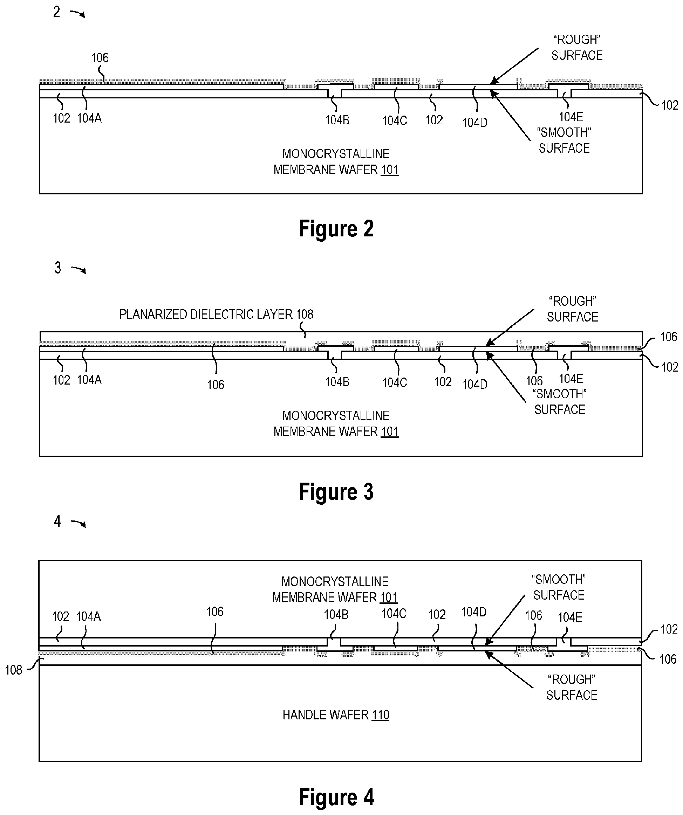

Having described an embodiment of a MEMS sensor device wafer assembly 1 from a structural standpoint, an example process sequence for fabricating the MEMS sensor device wafer assembly 1 will now be described with reference to Figures 2-9 which depict simplified cross section views of various exemplary fabrication steps for making the MEMS sensor device in accordance with selected embodiments of the present disclosure. While the depicted process sequence is provided with reference to making the MEMS sensor device wafer assembly 1 shown in Figure 1, it will be appreciated that the process is applicable to any one of numerous other MEMS devices, and that there are additional process steps that are not described, as these may be formed using any one of numerous processes, now known or developed in the future. Moreover, although for convenience the method is described using a particular order of steps, portions of the method could be performed in a different order or using different types of steps than what is described below.

Referring first to Figure 2, there is shown a partial cross-sectional view of a handling wafer structure 2 which includes a first substrate 101 and a plurality of defined insulator layers 102, 106, 108 and conductor layer(s) 104 formed over a first monocrystalline membrane wafer substrate 101. Depending on the type of device being fabricated, the first substrate 101 may be formed with a highly doped (e.g., n-type) monocrystalline membrane wafer substrate material, such as a bulk insulator substrate, a bulk metal substrate, a bulk silicon substrate, single crystalline silicon (doped or undoped), semiconductor-on-insulator (SOI) substrate, a multi-layered composite film wafer substrate or any semiconductor material including, for example, Si, SiC, SiGe, SiGeC, Ge, GaAs, InAs, InP as well as other Group III-IV compound semiconductors or any combination thereof. Though not shown, one or more alignment mark(s) can be formed in the first substrate 101 to assist with pattern etching using any desired marking process.

On a first or top surface of the first substrate 101, a first insulator layer 102 is formed (e.g., grown or deposited). In selected embodiments, the surface of the first substrate 101 is cleaned and a thin (e.g., 2 microns) layer of oxide is thermally grown to passivate the first substrate 101 and to serve an etch stop for future structural silicon etch processing (described hereinbelow). In addition or in the alternative, a field oxide layer, local oxidation of silicon (LOCOS), or oxide-nitride-oxide (ONO) layer may be formed. Thus, the insulator layer 102 may be implemented as silicon dioxide or some low-k dielectric material, but may include other materials such as phosphor-silicate glass (PSG) oxide, fluorinated silicon glass (FSG) oxide, silicon nitride, and/or other types of dielectric, including low-K dielectric materials with high thermal conductivity for cooling.

If desired, the first insulator layer 102 may be patterned and etched to form one or more openings to expose the first substrate 101. Alternatively, a partial etch may be applied to form patterned recessed openings in the first insulator layer 102. Though not shown, a patterned masking layer may be formed over the insulator layer 102, and any desired etching technique may be used to form the (recess) opening(s) in the insulator layer 102. The defined openings in the insulator layer 102 may provide an electrical interconnect path to the substrate 101 or otherwise define grounding contact regions to the first substrate 101 for a subsequently formed bond ring structure.

After forming the patterned insulator layer 102, a first conductive layer 104 may be formed, such as by depositing a poly layer 104 that may be doped or implanted to form the first conductive layer 104. In other embodiments, an epitaxial growth process may be used to form the depicted interconnect substrate contacts 104A-E from exposed portions of the first substrate 101, followed by an optional patterned etch process and/or planarization or polishing step for form the interconnect substrate contacts 104A-E. When formed with a doped polysilicon layer, the patterned first conductive layer 104 forms various mechanical and electrical functional structures such as vertical stop, vertical sensing electrodes, electrical interconnects, and bond ring structures on the first MEMS wafer device 100. In selected embodiments, the first conductive layer 104 is formed on the patterned insulator layer 102 and exposed first substrate 101 using any desired epitaxial growth, deposition, or sputtering process, such as chemical vapor deposition (CVD), plasma-enhanced chemical vapor deposition (PECVD), physical vapor deposition (PVD), atomic layer deposition (ALD), molecular beam deposition (MBD) or any combination(s) thereof. A suitable material for use as the first conductive layer 104 is doped polysilicon layer that is deposited to a predetermined thickness of less than 5 microns (e.g., 0.2-1 microns), though other conductive materials with different thicknesses may be used. However the first conductive layer 104 is formed, a patterned resist or mask layer (not shown) may be formed on the first conductive layer 104 to protect predetermined portions of the first conductive layer 104, and the exposed portions of the first conductive layer 104 are selectively etched and removed, thereby leaving portions of the first conductive layer 104, including interconnect conductors 104A, interconnect substrate contacts 104B, 104E to the substrate 101, structural connection elements 104C, and sensor electrode structures 104D in the movable mass or proof mass area. The pattern transfer and etching of the first conductive layer 104 may use one or more etching steps to remove the unprotected portions of the first conductive layer 104, including a dry etching process such as reactive-ion etching, ion beam etching, plasma etching or laser etching, a wet etching process wherein a chemical etchant is employed or any combination thereof. Though not shown, it will be appreciated that one or more additional insulators and/or conductive layers may also be formed over the first conductive layer 104 with additional deposition, pattern and etch processing steps.

In embodiments where the first conductive layer 104 is formed by depositing a doped polysilicon layer, it will be appreciated that the bottom surface of the first conductive layer 104 is relatively smooth when formed on an underlying thermal oxide or insulator layer 102 which has a relatively smooth upper surface. However, it will also be appreciated that the upper or top surface of the first conductive layer 104 is relatively rough due to the nature of the polycrystalline structure resulting from the poly deposition process.

After forming the patterned first conductive layer 104, a second insulator layer 106 may be formed, such as by depositing a layer of field nitride or alumina (Al₂0₃) over the semiconductor wafer structure 2 to cover the patterned first conductive layer 104, followed by an optional selective pattern and etch process to selectively form defined insulator layers 106. Subsequently, a planarized dielectric or insulator layer 108 may be formed over the defined insulator layers 106 to cover the semiconductor wafer structure 2.

Referring now to Figure 3, there is shown a partial cross-sectional view of the handling wafer structure 3 after a planarized dielectric layer 108 is formed. In selected embodiments, the planarized dielectric layer 108 may be formed by depositing and planarizing a layer of tetra-ethyl ortho-silicate (TEOS) or silane-based oxide over the semiconductor wafer structure 3 to cover the second insulator layer 106 and first conductive layer 104 and the patterned openings therein. In addition, a chemical mechanical polish process or other planarization step may be applied to planarize the planarized dielectric layer 108.

Referring now to Figure 4, there is shown a partial cross-sectional view of the handling wafer structure 4 after the monocrystalline membrane wafer structure 101 is flipped, attached to a handle wafer structure 110, and thinned. In selected embodiments, the handle wafer structure 110 is a single crystal silicon wafer with good surface smoothness, and provides mechanical support for subsequent processing of the monocrystalline membrane wafer structure 101. Prior to attaching the handle wafer structure 110 and membrane wafer structure 101, a suitable cleaning step is performed to prepare the handle wafer structure 110 for subsequent fusion bonding. After fusing the monocrystalline membrane wafer structure 101 and handle wafer structure 110, the single crystal silicon layer 101 may be thinned to a suitable or targeted thickness to form the eventual MEMS device layer. For example, a recess or polish process may be applied to thin the deposited membrane wafer substrate layer 101 down to a predetermined thickness (e.g., approximately 25 microns), though other thicknesses may be desired. Though not shown, a Germanium (Ge) layer may also be deposited and patterned on the top surface of the monocrystalline membrane wafer structure 101 to prepare for eutectic bonding with the cap wafer later.

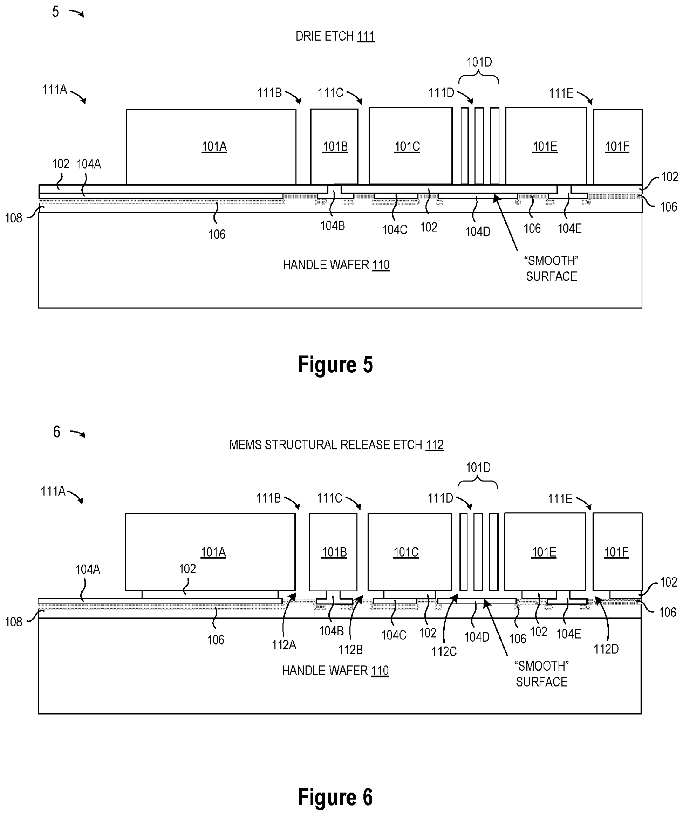

Referring now to Figure 5, there is shown a partial cross-sectional view of the handling wafer structure 5 after applying a patterned etch process 111 to the membrane wafer substrate layer 101 to form openings 111A-E which expose the underlying first insulator layer 102 and which define patterned monocrystalline membrane wafer structural elements 101A-F. In selected embodiments, one or more selective etch processes are applied to form the interconnect, bond, and seal ring structures, as well as the MEMS transducer elements, such as any mechanical elements in the MEMS sensor (e.g., a gyroscope sensor). For example, any suitable photolithography and deep reactive ion etch (DRIE) processes may be applied to fabricate the MEMS device structures using the single crystal silicon layer from the membrane wafer substrate 101. The selective etch of the membrane wafer substrate layer 101 forms an opening 111A which will expose the bond pad area in the finally formed MEMS device wafer assembly, and also forms openings 111B-E which define the patterned monocrystalline membrane wafer structural elements 101B-F. While the membrane wafer substrate layer 101 may be structurally etched using a DRIE process to define the active layer elements 100A-F, it will be appreciated that any desired pattern and etching processes may be used, including application and patterning of photoresist directly on the membrane wafer structural layer 101. In selected embodiments, the structural etch process is selected that is suitable for creating high-aspect ratio features.

Referring now to Figure 6, there is shown a partial cross-sectional view of the handling wafer structure 6 after applying one or more MEMS structural release etch process 112 to selectively remove exposed portions of the first insulator layer 102 and form electrode openings 112A-D, thereby defining all of the component parts of the MEMs sensor device. These component parts include the structural connection elements (e.g., 101B) and the bond ring structures (e.g., 101A, 101F) which are fixedly coupled to the handle wafer substrate 110. The component parts also include the seal ring structures (e.g., 101C, 101E) which are fixedly coupled to the handle wafer substrate 110 to surround the polycrystalline MEMS proof mass 101D. Finally, the component parts include the mechanical elements 101D of the MEMS sensor device, such as one or more proof mass structures, plates, flexures, frame, and hinges (not shown). In selected embodiments, the release etch process 112 may include a vapor release etch (VPE) which is applied to remove the thermal oxide layer 102 from below the MEMS proof mass 101D, thereby releasing these elements. For example, a single vapor hydrofluoric acid (vHF) etching step may be used to release the MEMS mechanical elements 101D by etching away exposed portions of the first insulator layer 102. The release etch process 112 also removes part of the first insulator layer 102 as part of the opening which will expose the bond pad area 111A in the finally formed MEMS device wafer assembly.

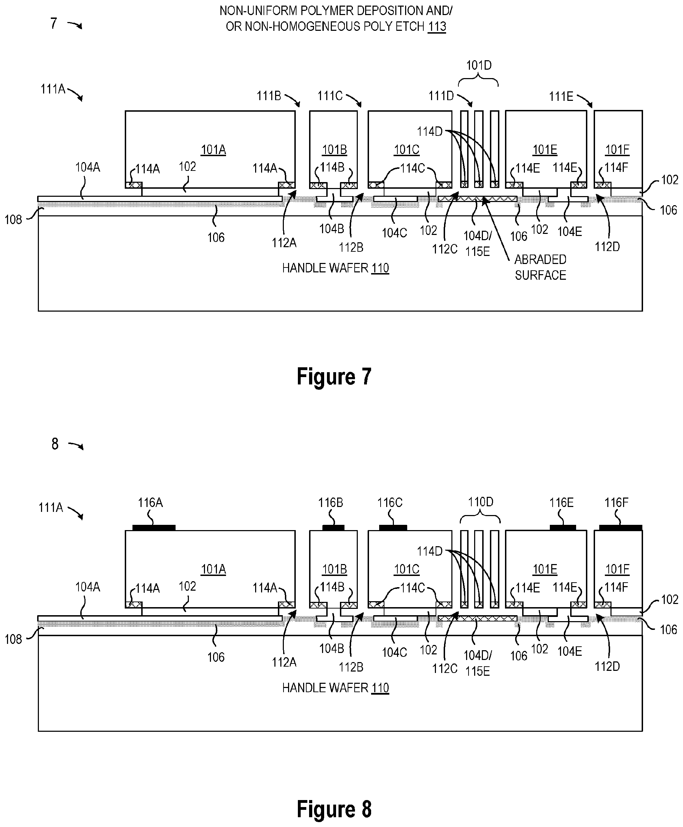

Referring now to Figure 7, there is shown a partial cross-sectional view of the handling wafer structure 7 after applying one or more processing steps 113 to roughen or abrade sensing gap surfaces of the patterned membrane wafer substrate layers 101A-F and/or poly electrode layer 104D, thereby forming roughened or abraded surface layers 114A-F, 115E. In selected embodiments, one or more processing steps 113 may include applying a non-homogeneous etch step which is controlled to non-uniformly etch the exposed surfaces 115E of the patterned poly electrode layer 104D. According to the invention, a non-homogeneous etch process 113 may employ a plasma etch using sulfur hexafluoride (SF₆) and oxygen (O₂) chemistry or a carbon fluorine chemistry which etches at least the poly grain boundaries and nearby areas faster on the upper sensing gap surface 115E of the poly electrode layer 104D, creating valleys in the grain boundary areas and peaks in the non-boundary regions. As a result, the surface roughness of the roughened or abraded patterned poly electrode layer 104D at the sensing gap surface 115E is increased.

In other selected embodiments, the processing steps 113 may include a very thin and non-uniform polymer deposition step, followed by a silicon etch step which etches the surface layers where formed and, in the process, removes the non-uniform polymer layer. With the polymer deposition step, the sensing gap surfaces at the bottom of the patterned membrane wafer substrate layers 100A-F and at the top of the sensing poly gate electrode 104D are coated with the non-uniform polymer. Of course, all exposed surfaces of the layers 101A-F, 104D will be coated with the polymer layer, but the relevant area of interest is the sensing gap surfaces. In an example embodiment, the non-uniform polymer deposition step may use a carbon fluorine chemistry to deposit the very thin and non-uniform polymer layers 114A-F, 115E. Due to the nature of the non-uniform polymer layers 114, 115, the subsequent silicon etching step results in a non-uniform etching of the sensing gap surfaces since the removal of the non-uniform polymer layers 114, 115 shields the underlying surfaces (but not the exposed surfaces) from etching, resulting in peak and valleys in the sensing gap surfaces 114 at the bottom of the patterned membrane wafer substrate layers 101A-F and in the sensing gap surface 115 at the top of the sensing electrode 104D. In selected embodiments, a suitable etch process can be a fluorine or chlorine etch chemistry. As a result, the surface roughness of the roughened or abraded patterned poly layers 114A-F and sensing electrode surface 104D/115E at the sensing gap surfaces is increased.

Referring now to Figure 8, there is shown a partial cross-sectional view of the handling wafer structure 8 after forming patterned bond anchor elements 116A-C, 116E-F on the top surface of the semiconductor wafer structure 8. In selected embodiments, the patterned bond anchor elements 116A-C, 116E-F are formed as patterned germanium anchor elements by depositing a layer of germanium 116 on the semiconductor wafer structure 8. To this end, the top surface of the semiconductor wafer structure 8 may be cleaned, and then a layer of germanium may be formed and then patterned and etched using the patterned resist or mask layer (not shown) to define germanium interconnect structures 116A-C, 116E-F in the interconnect, bond ring, and seal ring areas. If formed before etching the membrane wafer substrate layer 101, the deposited germanium layer 116 may be covered by a patterned hardmask layer (e.g., TEOS) that is used to both etch the germanium layer 116 and protect the resulting patterned germanium bond anchor elements 116A-C, 116E-F during subsequent etching of the membrane wafer substrate layer 101.

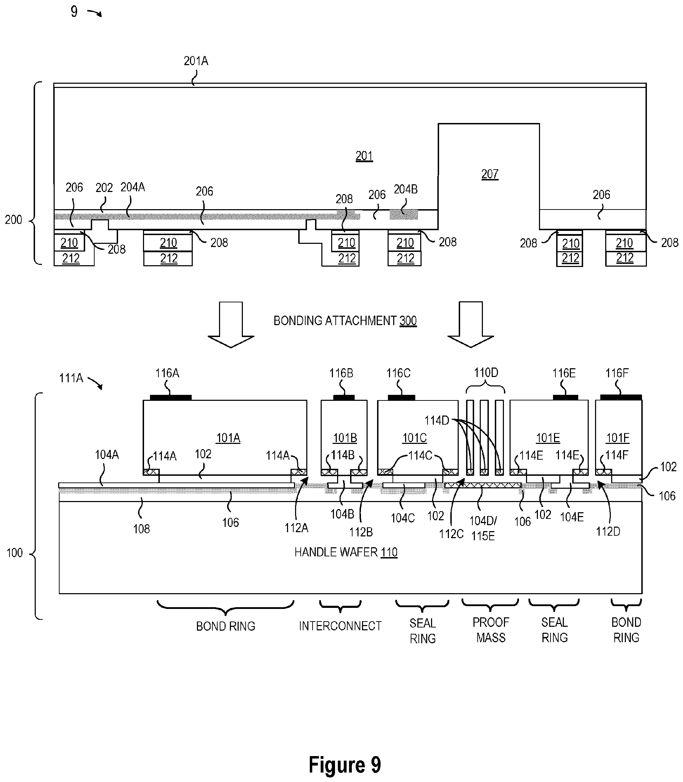

Referring now to Figure 9, there is shown a partial cross-sectional view 9 of a cap wafer structure 200 being attached to the membrane wafer substrate structure 100. As depicted, the cap wafer structure 200 includes a second substrate 201 and a plurality of defined insulator layers 202, 206, 208, 210, and conductor layers 204, 212 that are formed and patterned over the second substrate 201. Depending on the type of device being fabricated, the second substrate 201 may be implemented with monocrystalline semiconductor material, such as a bulk insulator substrate, a bulk metal substrate, a bulk silicon substrate, single crystalline silicon (doped or undoped), semiconductor-on-insulator (SOI) substrate, a multi-layered composite film wafer substrate or any semiconductor material including, for example, Si, SiC, SiGe, SiGeC, Ge, GaAs, InAs, InP as well as other Group III-IV compound semiconductors or any combination thereof. On a backside of the second substrate 201, a protective insulator layer 201A may be formed, such as by thermally growing an oxide layer 201a (e.g., silicon oxide) to a predetermined thickness.

To fabricate the cap wafer structure 200, a first insulator layer 202 is formed (e.g., grown or deposited) on a first or top surface of the second substrate 201, such as by cleaning the surface of the second substrate 201 and then thermally growing a thin (e.g., 2 microns) layer of passivation oxide or other insulator material, such as PSG oxide, FSG oxide, silicon nitride, and/or other types of dielectric, including low-K dielectric materials with high thermal conductivity for cooling.

In addition, the first insulator layer 202 may be patterned and selectively etched to form one or more openings to expose the second substrate 201. For example, a patterned masking layer (not shown) may be formed over the insulator layer 202, and a selective etch process may be applied to form openings in the insulator layer 202 that expose the second substrate 201 which provide an electrical interconnect path to conductive lines or paths (not shown) in the substrate 201.

After forming the insulator layer 202, a first conductive layer 204 may be formed by depositing a metal or conductive polysilicon layer on the cap wafer structure 200 using any desired deposition or sputtering process, such as CVD, PECVD, PVD, ALD, MBD or any combination(s) thereof. In selected embodiments, the first conductive layer may be a deposited aluminum layer. Once deposited, the first conductive layer 204 may be patterned and etched to define electrode, interconnect, and bond ring structures on the first cap wafer structure 200. For example, a patterned resist or mask layer (not shown) may be formed to protect predetermined portions of the first conductive layer 204 and exposed portions of the first conductive layer 204 may be selectively etched and removed, thereby leaving portions of the first conductive layer 204, including interconnect conductors 204A and interconnect substrate contacts 204B to the substrate 201, though other patterned conductive layers (e.g., interconnect structures and sensor electrode structures) may also be formed. The pattern transfer and etching of the first conductive layer 204 may use one or more etching steps to remove the unprotected portions of the first conductive layer 204, including a dry etching process such as reactive-ion etching, ion beam etching, plasma etching or laser etching, a wet etching process wherein a chemical etchant is employed or any combination thereof.

In selected embodiments, the patterned first conductive layer 204 is used for bonding the cap wafer structure 200 to the membrane wafer substrate structure 100. For example, a patterned first conductive layer 204 of aluminum may be used for the dual purposes of conductive interconnect and Al-Ge bonding with the patterned bond anchor elements 116A-C, 116E-F, thereby eliminating the need to form separate standoff structures 206, 208, 210, 212 as described hereinbelow.

However, in other embodiments, separate standoff structures are formed on the patterned first conductive layer 204 by forming a second insulator layer 206 on the cap wafer structure 200, such as by depositing one or more interlayer dielectric (ILD) layers over the cap wafer structure 200 to a predetermined thickness. In selected embodiments, the second insulator layer 206 may be formed by depositing and planarizing a first cap oxide layer 206 over the cap wafer structure 200 to cover the first conductive layer 204 and the patterned openings therein. Subsequently, a cap etch stop layer 208 (e.g., silicon nitride) and second cap oxide layer 210 are sequentially deposited, patterned, and etched to form patterned standoff elements 208/210 which are positioned for alignment with the patterned bond anchor elements 116A-C, 116E-F during bonding. In addition, one or more patterned etch processes may be applied to selectively etch the first cap oxide layer 206 and expose the underlying first conductive layer 204 at predetermined via openings.

In preparation for bonding, patterned cap metal bond anchor elements 212 are formed on the cap wafer structure 200. For example, when the metal bond anchor elements 212 are formed with patterned aluminum, an aluminum layer may be deposited or sputtered to a predetermined thickness (e.g., 1-2 microns), though other deposition processes, materials, and thicknesses may be used. Once deposited, a photolithographic mask and etch processing is applied to define the aluminum bond anchor elements 212 which are positioned in the bond pad area and for alignment with the patterned bond anchor elements 116A-C, 116E-F from the first MEMS wafer device 100. While Figure 9 shows two patterned interconnect layers 210, 212 are formed on the cap wafer structure 200, those skilled in the art will appreciate that the cap wafer structure 200 may also be formed with additional (three or more) or fewer (one) electrical interconnect layers.

Before or after formation of the patterned cap metal bond anchor elements 216, a cap cavity 207 may be formed in the second substrate 201 by patterning and etching the cap wafer structure 200. For example, a patterned cap resist or mask layer (not shown) may be formed to expose and remove the cap oxide layer 206 over the intended cap cavity 207, followed by selectively removal of the exposed portions of the second substrate 201 to form a cap cavity 207 to a predetermined depth and width which is positioned for alignment with the patterned polycrystalline MEMS proof mass 101D from the MEMS wafer device 100. The pattern transfer and etching of the second substrate 201 may use one or more silicon etching steps, including a dry etching process such as reactive-ion etching, ion beam etching, plasma etching or laser etching, a wet etching process wherein a chemical etchant is employed or any combination thereof.

As illustrated in Figure 9, the cap wafer structure 200 has been flipped upside down in preparation for bonding attachment 300 to the top of the fusion-bonded membrane/handle wafer structure 100. In preparation for bonding, the handling wafer structure 100 and the cap wafer structure 200 may each be cleaned, such as by using a non-oxidizing ash chemistry or solvent-based wet removal process which does not oxidize the underlying metal layers. In selected embodiments, the MEMS handling wafer structure 100 and cap wafer structure 200 are bonded together using metal compression bonding techniques, such as a combination of thermal and pressure bonding. For example, AlGe bonding techniques may be used to provide both a hermetic sealing of the cavities (e.g., 207) enclosing the released MEMS structures, and the electrical connections between the MEMS structures to the cap wafer structure 200.

The metal thermocompression bonding techniques described hereinabove provide a hermetic barrier between the MEMS transducer structures 101D (formed from the MEMS handling wafer structure 100) and the ambient environment which is superior to the sealing performance provided by oxide or glass sealing techniques. However, it is contemplated that other bonding techniques may be used to obtain additional sealing protections. For example, instead of using thermocompression bonding techniques to bond the aligned aluminum bond anchor elements 212 and 116A-C, 116E-F, the bond anchor elements 116A-C, 116E-F are replaced with patterned germanium anchor elements 116A-C, 116E-F so that an aluminum-germanium eutectic bond may be formed to bond the MEMS handling wafer structure 100 and the cap wafer structure 200 together. To this end, the protective cap wafer structure 200 and MEMS handling wafer structure 100 are bonded together using an aluminum-germanium eutectic bond under vacuum conditions. As a result, the high aspect ratio polycrystalline MEMS proof mass structures 110D formed from the MEMS handling wafer structure 100 can be hermetically sealed.

In other embodiments where the bond anchor elements 212 and 116A-C, 116E-F are formed with patterned aluminum, the aluminum layers may be bonded together using thermocompression bonding whereby the anchor elements are aligned in contact while heat and compression is applied to bond the aligned anchor elements to one another. In selected example embodiments, thermocompression bonding may be implemented by applying pressure at or above a predetermined threshold (e.g., 30MPa) in combination with a relatively low temperature heat process (e.g., at or below 500 degrees Celsius). For example, aluminum thermocompression bonding may be implemented by aligning and compressing the first MEMS handling wafer structure 100 and cap wafer structure 200 with 70-90 kiloNewtons of force while heating the wafer structures 100, 200 to 400-500 degrees Celsius for approximately 30-50 minutes. By attaching the MEMS handling wafer structure 100 to the first cap wafer structure 200 using a metal-to-metal bond technique, the MEMS transducer structures formed from the MEMS handling wafer structure 100 can be hermetically sealed by the bonding and seal ring structures 208/210/212/116/110/106/104.

As will be appreciated, additional or different processing steps may be used to complete the fabrication of the depicted MEMS device wafer assembly into functioning devices. In addition to various front end processing steps (such as sacrificial oxide formation, stripping, isolation region formation, implantation, spacer formation, annealing, silicide formation, and polishing steps), additional backend processing steps may be performed, such as forming contact plugs and multiple levels of interconnect(s) that are used to connect the device components in a desired manner to achieve the desired functionality. Thus, the specific sequence of steps used to complete the fabrication of the device components may vary, depending on the process and/or design requirements. It is understood that the terms so used are interchangeable under appropriate circumstances such that the various embodiments described herein are, for example, capable of operation in other orientations than those illustrated or otherwise described herein.

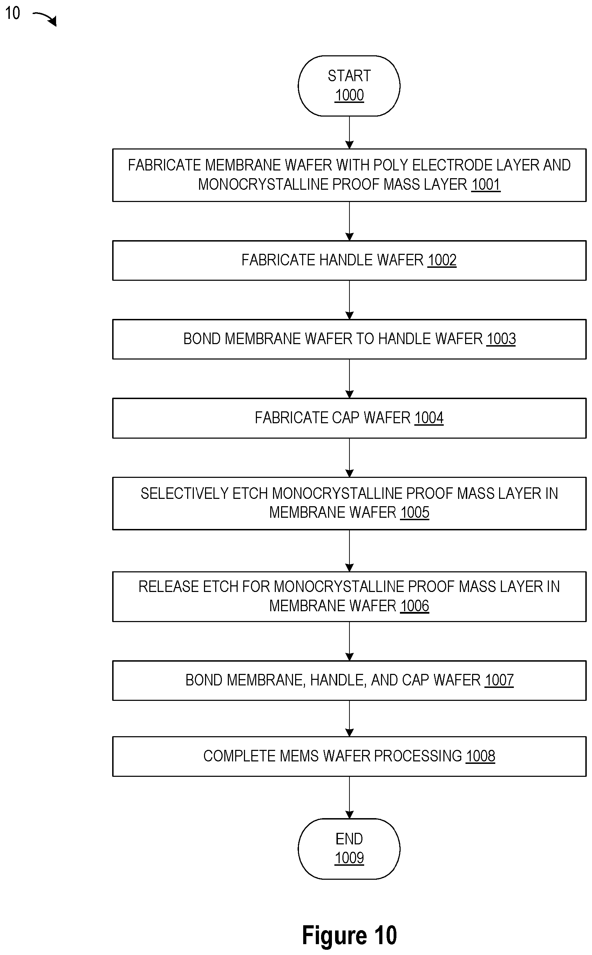

To provide additional details for an improved contextual understanding of selected embodiments of the present disclosure, reference is now made to Figure 10 which depicts a simplified flow chart 10 showing the processing steps 1000-1009 for fabricating a MEMS sensor device with reduced Z-axis stiction. After the process begins at step 1000, a membrane wafer having a poly electrode layer and monocrystalline proof mass layer is fabricated (step 10001). As will be appreciated, the membrane wafer 101 may be fabricated on a first crystal silicon wafer substrate using a sequence of processing steps to deposit, pattern and etch insulator layers and conductive poly sense electrode layers to define MEMS wafer interconnect layers and sense electrode layers. For example, Figure 3 shows a semiconductor wafer structure 3 having a monocrystalline proof mass layer 101, a plurality of insulator layers 102, 106, 108, conductive poly electrode layers 104, and one or more covering insulator layers 106, 108.

At step 1002, a handle wafer 110 is fabricated. As will be appreciated, the handle wafer may be fabricated with a second crystal silicon wafer substrate.

At step 1003, the membrane wafer 101 is bonded to the handle wafer. In this way, the handle wafer provides mechanical support for subsequent processing of the membrane wafer. For example, Figure 4 shows the handling wafer structure 4 wherein a handling wafer 110 is bonded to the planarized dielectric layer 108 on the membrane wafer 101. After bonding the membrane wafer to the handle wafer, the monocrystalline proof mass layer 101 of the membrane wafer 101 may be thinned to a targeted thickness to form the eventual MEMS device layer.

At step 1004, a cap wafer is fabricated. As will be appreciated, the cap wafer may be fabricated with a third crystal silicon wafer substrate which is separately processed with a sequence of processing steps to deposit, pattern and etch insulator layers and conductive layers. For example, the cap wafer may be processed to form an array of through silicon vias (TSVs) using a deep reactive ion etch (DRIE) process 111 to selectively etch the third crystal silicon wafer substrate, followed by a polysilicon deposition process and chemical mechanical polish step to form the TSVs.

At step 1005, the monocrystalline proof mass layer on the membrane wafer is selectively etched. For example, a patterned transducer resist or mask layer is formed on the monocrystalline proof mass layer to protect selected portions of the monocrystalline proof mass layer, and then the exposed portions of the monocrystalline proof mass layer may be selectively etched and removed with a deep reactive ion etch (DRIE) process. The selective etching of the monocrystalline proof mass layer defines monocrystalline MEMS proof mass elements which are fixed to the membrane wafer.

At step 1006, a release etch process is applied to the membrane wafer to release the monocrystalline MEMS proof mass elements. In selected embodiments, the release etch process may include a vapor release etch (VPE) that is applied to remove a sacrificial dielectric or insulator layer from below the MEMS proof mass elements, thereby releasing these elements.

At step 1007, the membrane wafer and handle wafer are bonded to the cap wafer. In selected embodiments, the cap wafer is bonded with the combined membrane/handle wafer using AlGe eutectic bonding.

At step 1008, additional MEMs wafer processing steps are applied. For example, the cap wafer may be thinned, and contacts to the TSV and redistribution routing layers (RDLs) are fabricated before the final passivation step.

At step 1009, the fabrication process ends.

By now, it will be appreciated that there has been provided herein a MEMS sensor device and associated method for fabricating same. The disclosed MEMS sensor device includes a first inertial transducer element formed in a multi-layer semiconductor structure. In selected embodiments, the first inertial transducer element is a z-axis accelerometer sensor. The disclosed MEMS sensor device also includes a cap device bonded to the multi-layer semiconductor structure to protect the first inertial transducer element from ambient environmental conditions. In selected embodiments, the cap device is bonded to the multi-layer semiconductor structure with a high temperature eutectic seal ring bonding structure to form a vacuum in a first sensor cavity which houses the first inertial transducer element. As disclosed, the first inertial transducer element includes a first monocrystalline semiconductor proof mass element and a second conductive electrode element separated from one another by an air sensing gap. In selected embodiments, the first monocrystalline semiconductor proof mass element is a cantilevered monocrystalline silicon beam anchored to the multi-layer semiconductor structure. In addition, the second conductive electrode element may include a conductive layer (e.g., conductive polycrystalline layer) formed in the multi-layer semiconductor structure to be positioned in alignment with but separated from the cantilevered monocrystalline silicon beam. In the disclosed first inertial transducer element, at least a first sensing gap surface of the first monocrystalline semiconductor proof mass element is a first rough surface that has been selectively etched to reduce stiction between the first monocrystalline semiconductor proof mass element and the second conductive electrode element. In selected embodiments, at least a second sensing gap surface of the second conductive electrode element is a second rough surface that has been selectively etched to reduce stiction between the first monocrystalline semiconductor proof mass element and the second conductive electrode element. In other selected embodiments, at least the first sensing gap surface of the first monocrystalline semiconductor proof mass element includes a non-uniform layer of deposited polymer that has been selectively etched to form the first rough surface on at least the first sensing gap surface. In other selected embodiments, at least the second sensing gap surface of the second conductive electrode element includes a non-uniform layer of deposited polymer that has been selectively etched to form the second rough surface on at least the second sensing gap surface.

In another form, there is provided a transducer and associated method for fabrication. In the disclosed methodology, a MEMS wafer structure is provided that includes a first semiconductor electrode and a first semiconductor layer that is formed over the first semiconductor electrode. In selected embodiments, the first semiconductor electrode is formed as a polycrystalline silicon electrode, and the first semiconductor layer is formed as a first monocrystalline semiconductor layer. In other embodiments, the first semiconductor electrode is formed as a polycrystalline silicon electrode, and the first semiconductor layer is formed as a first polycrystalline semiconductor layer. The disclosed method also includes selectively etching the first semiconductor layer to form a first MEMS inertial transducer element and surrounding frame support elements. In selected embodiments, the first semiconductor layer is selectively etched by etching the first semiconductor layer with a deep reactive ion etch process to form the first MEMS inertial transducer element as a high aspect ratio proof mass transducer element (e.g., a z-axis accelerometer sensor). In addition, the disclosed method includes applying a structural release etch process to release the first MEMS inertial transducer element and to expose a first sensing gap surface of the first MEMS inertial transducer element and a second sensing gap surface of the first semiconductor electrode. In selected embodiments, the structural release etch process may be applied using a vapor release etch to remove a sacrificial dielectric layer formed between the semiconductor electrode and the first semiconductor layer. The disclosed method also includes applying a surface abrasion etch process to roughen one or both of the first sensing gap surface of the first MEMS inertial transducer element or the second sensing gap surface of the first semiconductor electrode, thereby reducing stiction between the first MEMS inertial transducer element and the first semiconductor electrode. In selected embodiments, the surface abrasion etch process may be applied using a non-homogeneous plasma etch which etches crystalline grain boundary regions in either or both of the first MEMS inertial transducer element or the first semiconductor electrode faster than non-boundary regions in either or both of the first MEMS inertial transducer element or the first semiconductor electrode. In other selected embodiments, the surface abrasion etch process may be applied by depositing a non-uniform polymer layer on at least the first and second sensing gap surfaces; and applying a semiconductor etch process which roughens the first and second sensing gap surfaces by selectively etching the first MEMS inertial transducer element and the first semiconductor electrode not protected by the non-uniform polymer layer. In addition, the disclosed method includes attaching a first cap wafer structure to the MEMS wafer structure using a first bonding process. In selected embodiments, the first cap wafer structure may be attached to the MEMS wafer structure by bonding the first cap wafer structure to the MEMS wafer structure with a high temperature eutectic seal ring bonding structure to form a vacuum in a first sensor cavity of the cap wafer structure which houses the first MEMS inertial transducer element.

In yet another form, there is provided a high aspect ratio transducer and method for making same. The disclosed transducer includes a first cap structure which includes a substrate, a plurality of first metal interconnect bond spacer structures, and a high vacuum cavity formed in the substrate to define a first inertial transducer space. The disclosed transducer also includes a first semiconductor substrate structure attached to the plurality of first metal interconnect bond spacer structures, where the first semiconductor substrate structure includes a first surface on which a second patterned metallic layer is formed and bonded to the plurality of first metal interconnect bond spacer structures, a first high aspect ratio proof mass element which is aligned with the first inertial transducer space, and a second surface on which a plurality of spacer structures are formed to define an out-of-plane semiconductor sensing electrode space. In addition, the disclosed transducer includes a second semiconductor substrate structure attached to the plurality of spacer structures and comprising an out-of-plane semiconductor sensing electrode which is aligned with the first high aspect ratio proof mass element. In the disclosed transducer, at least a first sensing gap surface of the first high aspect ratio proof mass element is a first rough surface that has been selectively etched to reduce stiction between the first high aspect ratio proof mass element and the out-of-plane semiconductor sensing electrode. In selected embodiments, the first high aspect ratio proof mass element is a cantilevered monocrystalline silicon beam anchored to the first semiconductor substrate structure, and the out-of-plane semiconductor sensing electrode is a polycrystalline silicon electrode layer formed in the second semiconductor substrate structure. In other selected embodiments, at least second sensing gap surface of the out-of-plane semiconductor sensing electrode is a second rough surface that has been selectively etched to reduce stiction between the first high aspect ratio proof mass element and the out-of-plane semiconductor sensing electrode.

Various illustrative embodiments of the present disclosure have been described in detail with reference to the accompanying figures. While various details are set forth in the foregoing description, it will be appreciated that the present disclosure may be practiced without these specific details, and that numerous implementation-specific decisions may be made to the disclosure described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of example MEMS device wafer structures without including every device feature or geometry in order to avoid limiting or obscuring the present disclosure. In addition, the methodology of the present disclosure may be applied using materials other than expressly set forth herein. In addition, the process steps may be performed in an alternative order than what is presented. For example, the sequence of wafer bonding steps may be reversed. In addition, it is noted that, throughout this detailed description, certain layers of materials will be deposited and removed to form the depicted MEMS device wafer structures. Where the specific procedures for depositing or removing such layers are not detailed, any desired technique may be used for depositing, removing or otherwise forming such layers at appropriate thicknesses. Such details are well known and not considered necessary to teach one skilled in the art of how to make or use the present disclosure. And while the disclosed MEMS devices may be implemented with accelerometer and/or gyroscope sensors, the fabrication process described herein is not limited to such MEMS sensors or any other type of sensor, but is also applicable to any one of numerous MEMS devices that include some type of structure that is movably suspended by one or more springs and that is formed by bonding an active wafer to a reference wafer. Non-limiting examples of such devices include various types of accelerometers and switches, optical MEMS system components, and other MEMS system devices that use drive and sense electrodes.

It is also noted that, throughout this detailed description, certain elements in the figures are illustrated for simplicity and clarity and have not necessarily been drawn to scale so that the illustrated dimensions of some of the elements in the figures may be exaggerated relative to other elements to help improve the understanding of the embodiments.

## Claims

1. A MEMS sensor device (1), comprising:
a first inertial transducer element (100) formed in a multi-layer semiconductor structure (101); and
a cap device (200) bonded to the multi-layer semiconductor structure (101) to protect the first inertial transducer element (100) from ambient environmental conditions,
where the first inertial transducer element (100) comprises a first monocrystalline semiconductor proof mass element (101D) and a second conductive electrode element (104D) separated from one another by an air sensing gap, and
where at least a first sensing gap surface (114D) of the first monocrystalline semiconductor proof mass element (101D) is a first rough surface that has been selectively etched to reduce stiction between the first monocrystalline semiconductor proof mass element (101D) and the second conductive electrode element (104D), and
**characterised in that**
the first rough surface is selectively etched by a non-homogeneous plasma etch (113) which etches crystalline grain boundary regions in the first monocrystalline semiconductor proof mass element (101D) faster than non-boundary regions in the first monocrystalline semiconductor proof mass element (101D).

2. The MEMS sensor device (1) of claim 1, where at least a second sensing gap surface (115E) of the second conductive electrode element (104D) is a second rough surface that has been selectively etched by a non-homogeneous plasma etch (113) which etches crystalline grain boundary regions in the second conductive electrode element (104D) faster than non-boundary regions in the second conductive electrode element (104D) to reduce stiction between the first monocrystalline semiconductor proof mass element (101D) and the second conductive electrode element (104D).

3. The MEMS sensor device (1) of claim 1 or 2, where the first inertial transducer element (100) comprises a z-axis accelerometer sensor.

4. The MEMS sensor device (1) of any preceding claim, where the first monocrystalline semiconductor proof mass element (101D) comprises a cantilevered monocrystalline silicon beam anchored to the multi-layer semiconductor structure (101).

5. The MEMS sensor device (1) of claim 4, where the second conductive electrode element (104D) comprises a conductive polysilicon layer formed in the multi-layer semiconductor structure (101) to be positioned in alignment with but separated from the cantilevered monocrystalline silicon beam.

6. The MEMS sensor device (1) of any preceding claim, where the cap device (200) is bonded to the multi-layer semiconductor structure (101) with a high temperature eutectic seal ring bonding structure (101C, 101E) to form a vacuum in a first sensor cavity (207) which houses the first inertial transducer element (100).

7. The MEMS sensor device (1) of any preceding claim, where at least the first sensing gap surface (114D) of the first monocrystalline semiconductor proof mass element (101D) includes a non-uniform layer of deposited polymer that has been selectively etched to form the first rough surface.

8. The MEMS sensor device (1) of claim 2 or any one of claims 3 to 7 when dependent on claim 2, where at least the second sensing gap surface (115E) of the second conductive electrode element (104D) includes a non-uniform layer of deposited polymer that has been selectively etched to form the second rough surface.

9. A method for fabricating a transducer comprising:
providing a MEMS wafer structure comprising a first semiconductor electrode and a first semiconductor layer that is formed over the first semiconductor electrode;
selectively etching (1005) the first semiconductor layer to form a first MEMS inertial transducer element and surrounding frame support elements;
applying (1006) a structural release etch process to release the first MEMS inertial transducer element and to expose a first sensing gap surface of the first MEMS inertial transducer element and a second sensing gap surface of the first semiconductor electrode;
applying a surface abrasion etch process to roughen one or both of the first sensing gap surface of the first MEMS inertial transducer element or the second sensing gap surface of the first semiconductor electrode, thereby reducing stiction between the first MEMS inertial transducer element and the first semiconductor electrode; and
attaching (1007) a first cap wafer structure to the MEMS wafer structure using a first bonding process ;
**characterised in that** :
applying the surface abrasion etch process comprises applying a non-homogeneous plasma etch (113) which etches crystalline grain boundary regions in either or both of the first MEMS inertial transducer element or the first semiconductor electrode faster than non-boundary regions in either or both of the first MEMS inertial transducer element or the first semiconductor electrode.

10. The method of claim 9, where providing the MEMS wafer structure comprises forming the first semiconductor electrode as a polycrystalline silicon electrode over which the first semiconductor layer is formed as a first monocrystalline semiconductor layer.

11. The method of claim 9, where providing the MEMS wafer structure comprises forming the first semiconductor electrode as a polycrystalline silicon electrode over which the first semiconductor layer is formed as a first polycrystalline semiconductor layer.

12. The method of any one of claims 9 to 11, where selectively etching (1005) the first semiconductor layer comprises etching the first semiconductor layer with a deep reactive ion etch process to form the first MEMS inertial transducer element as a high aspect ratio proof mass transducer element.

13. The method of claim 12, where the high aspect ratio proof mass transducer element comprises a z-axis accelerometer sensor.

14. The method of any one of claims 9 to 13, where applying (1006) the structural release etch process comprises applying a vapor release etch to remove a sacrificial dielectric layer formed between the semiconductor electrode and the first semiconductor layer.

## Patentansprüche

1. MEMS-Sensorvorrichtung (1), die Folgendes umfasst:
ein erstes Trägheitswandlerelement (100), das in einer mehrschichtigen Halbleiterstruktur (101) ausgebildet ist; und
eine mit der mehrschichtigen Halbleiterstruktur (101) verbundene Kappenvorrichtung (200), um das erste Trägheitswandlerelement (100) vor Umgebungsbedingungen zu schützen,
wobei das erste Trägheitswandlerelement (100) ein erstes monokristallines halbleiterfestes Masseelement (101D) und ein zweites leitfähiges Elektrodenelement (104D) umfasst, die durch einen Luftmessspalt voneinander getrennt sind, und
wobei mindestens eine erste Messspaltoberfläche (114D) des ersten monokristallinen halbleiterfesten Masseelements (101D) eine erste raue Oberfläche ist, die selektiv geätzt wurde, um die Steifigkeit zwischen dem ersten monokristallinen halbleiterfesten Masseelement (101D) und dem zweiten leitfähigen Elektrodenelement (104D) zu reduzieren, und
**dadurch gekennzeichnet, dass**
die erste raue Oberfläche selektiv durch ein nicht homogenes Plasmaätzen (113) geätzt wird, das kristalline Korngrenzbereiche in dem ersten monokristallinen halbleiterfesten Masseelement (101D) schneller ätzt als Nicht-Grenzbereiche in dem ersten monokristallinen halbleiterfesten Masseelement (101D).

2. MEMS-Sensorvorrichtung (1) nach Anspruch 1, wobei mindestens eine zweite Messspaltoberfläche (115E) des zweiten leitfähigen Elektrodenelements (104D) eine zweite raue Oberfläche ist, die durch ein nicht homogenes Plasmaätzen (113) selektiv geätzt wurde, das kristalline Korngrenzbereiche in dem zweiten leitfähigen Elektrodenelement (104D) schneller ätzt als Nicht-Grenzbereiche in dem zweiten leitfähigen Elektrodenelement (104D) ätzt, um die Steifigkeit zwischen dem ersten monokristallinen halbleiterfesten Masseelement (101D) und dem zweiten leitfähigen Elektrodenelement (104D) zu reduzieren.

3. MEMS-Sensorvorrichtung (1) nach Anspruch 1 oder 2, wobei das erste Trägheitswandlerelement (100) einen Beschleunigungsmessersensor der Z-Achse umfasst.

4. MEMS-Sensorvorrichtung (1) nach einem der vorhergehenden Ansprüche, wobei das erste monokristalline halbleiterfeste Masseelement (101D) einen freitragenden monokristallinen Siliziumbalken umfasst, der an der mehrschichtigen Halbleiterstruktur (101) verankert ist.

5. MEMS-Sensorvorrichtung (1) nach Anspruch 4, wobei das zweite leitfähige Elektrodenelement (104D) eine leitfähige Polysiliziumschicht umfasst, die in der mehrschichtigen Halbleiterstruktur (101) ausgebildet ist, um mit dem freitragenden monokristallinen Siliziumbalken ausgerichtet, aber von ihm getrennt zu positioniert zu werden.

6. MEMS-Sensorvorrichtung (1) nach einem der vorhergehenden Ansprüche, wobei die Kappenvorrichtung (200) mit der mehrschichtigen Halbleiterstruktur (101) durch eine eutektische hochtemperatur-Dichtungsringbindungsstruktur (101C, 101E) verbunden ist, um ein Vakuum in einem ersten Sensorhohlraum (207) zu bilden, der das erste Trägheitswandlerelement (100) aufnimmt.

7. MEMS-Sensorvorrichtung (1) nach einem der vorhergehenden Ansprüche, wobei mindestens die erste Messspaltoberfläche (114D) des ersten monokristallinen halbleiterfesten Masseelements (101D) eine nicht gleichmäßige Schicht aus abgelagertem Polymer einschließt, die selektiv geätzt wurde, um die erste raue Oberfläche zu bilden.

8. MEMS-Sensorvorrichtung (1) nach Anspruch 2 oder einem der Ansprüche 3 bis 7, wenn sie von Anspruch 2 abhängt, wobei mindestens die zweite Messspaltoberfläche (115E) des zweiten leitfähigen Elektrodenelements (104D) eine nicht gleichmäßige Schicht aus abgelagertem Polymer einschließt, die selektiv geätzt wurde, um die zweite raue Oberfläche zu bilden.

9. Verfahren zur Herstellung eines Wandlers, umfassend:
Bereitstellen einer MEMS-Waferstruktur, die eine erste Halbleiterelektrode und eine erste Halbleiterschicht umfasst, die über der ersten Halbleiterelektrode ausgebildet ist;
selektives Ätzen (1005) der ersten Halbleiterschicht, um ein erstes MEMS-Trägheitswandlerelement und umgebende Rahmenstützelemente zu bilden;
Anwenden (1006) eines strukturellen Freilegungsätzverfahrens zum Lösen des ersten MEMS-Trägheitswandlerelements und zum Freilegen einer ersten Messspaltoberfläche des ersten MEMS-Trägheitswandlerelements und einer zweiten Messspaltoberfläche der ersten Halbleiterelektrode;
Anwenden eines Oberflächenabriebätzverfahrens, um eine von der ersten Messspaltoberfläche des ersten MEMS-Trägheitswandlerelements oder der zweiten Messspaltoberfläche der ersten Halbleiterelektrode oder beide aufzurauen, wodurch die Steifigkeit zwischen dem ersten MEMS-Trägheitswandlerelement und der ersten Halbleiterelektrode reduziert wird; und
Befestigen (1007) einer ersten Kappe-Wafer-Struktur an der MEMS-Wafer-Struktur mithilfe eines ersten Klebeverfahrens;
**dadurch gekennzeichnet, dass**
das Anwenden des Oberflächenabriebätzverfahrens das Anwenden eines nicht homogenen Plasmaätzens (113) umfasst, das kristalline Korngrenzbereiche in einem oder beiden von dem ersten MEMS-Trägheitswandlerelement oder der ersten Halbleiterelektrode schneller ätzt als Nicht-Grenzbereiche in einem oder beiden von dem ersten MEMS-Trägheitswandlerelement oder der ersten Halbleiterelektrode.

10. Verfahren nach Anspruch 9, wobei das Bereitstellen der MEMS-Waferstruktur das Bilden der ersten Halbleiterelektrode als polykristalline Siliziumelektrode umfasst, über die die erste Halbleiterschicht als erste monokristalline Halbleiterschicht ausgebildet wird.

11. Verfahren nach Anspruch 9, wobei das Bereitstellen der MEMS-Waferstruktur das Bilden der ersten Halbleiterelektrode als polykristalline Siliziumelektrode umfasst, über die die erste Halbleiterschicht als erste polykristalline Halbleiterschicht ausgebildet wird.

12. Verfahren nach einem der Ansprüche 9 bis 11, wobei das selektive Ätzen (1005) der ersten Halbleiterschicht das Ätzen der ersten Halbleiterschicht mit einem tief reaktiven Ionenätzverfahren umfasst, um das erste MEMS-Trägheitswandlerelement als Prüfmasse-Wandlerelement mit hohem Aspektverhältnis zu bilden.

13. Verfahren nach Anspruch 12, wobei das Prüfmasse-Wandlerelement mit hohem Aspektverhältnis einen Beschleunigungsmessersensor der Z-Achse umfasst.

14. Verfahren nach einem der Ansprüche 9 bis 13, wobei das Anwenden (1006) des strukturellen Freilegungsätzverfahrens das Anwenden eines Dampf-Freilegungsätzens umfasst, um eine zwischen der Halbleiterelektrode und der ersten Halbleiterschicht ausgebildete dielektrische Opferschicht zu entfernen.

## Revendications

1. Dispositif de capteur MEMS (1) comprenant :
un premier élément de transducteur inertiel (100) formé dans une structure semiconductrice multicouche (101) ; et
un dispositif de capot (200) collé à la structure semiconductrice multicouche (101) pour protéger le premier élément de transducteur inertiel (100) des conditions environnementales ambiantes,
dans lequel le premier élément de transducteur inertiel (100) comprend un premier élément de masse étalon en semiconducteur monocristallin (101D) et un deuxième élément d'électrode conductrice (104D) séparés l'un de l'autre par un espace de mesure d'air, et
dans lequel au moins une première surface d'espace de mesure (114D) du premier élément de masse étalon en semiconducteur monocristallin (101D) est une première surface rugueuse qui a été gravée de manière sélective afin de réduire le frottement au démarrage entre le premier élément de masse étalon en semiconducteur monocristallin (101D) et le deuxième élément d'électrode conductrice (104D), et
**caractérisé en ce que** la première surface rugueuse est gravée de manière sélective par une gravure au plasma non homogène (113) qui grave des régions de frontière de grains cristallins dans le premier élément de masse étalon en semiconducteur monocristallin (101D) plus vite que les régions non frontières dans le premier élément de masse étalon en semiconducteur monocristallin (101D).

2. Dispositif de capteur MEMS (1) selon la revendication 1, dans lequel au moins une deuxième surface d'espace de mesure (115E) du deuxième élément d'électrode conductrice (104D) est une deuxième surface rugueuse qui a été gravée de manière sélective par une gravure au plasma non homogène (113) qui grave des régions de frontière de grains cristallins dans le deuxième élément d'électrode conductrice (104D) plus vite que les régions non frontières dans le deuxième élément d'électrode conductrice (104D) afin de réduire le frottement au démarrage entre le premier élément de masse étalon en semiconducteur monocristallin (101D) et le deuxième élément d'électrode conductrice (104D).

3. Dispositif de capteur MEMS (1) selon la revendication 1 ou 2, dans lequel le premier élément de transducteur inertiel (100) comprend un capteur à accéléromètre d'axe z.

4. Dispositif de capteur MEMS (1) selon l'une quelconque des revendications précédentes, dans lequel le premier élément de masse étalon en semiconducteur monocristallin (101D) comprend une barrette de silicium monocristallin en porte-à-faux ancrée dans la structure semiconductrice multicouche (101).

5. Dispositif de capteur MEMS (1) selon la revendication 4, dans lequel le deuxième élément d'électrode conductrice (104D) comprend une couche de polysilicium conducteur formée dans la structure semiconductrice multicouche (101) pour être positionnée en alignement avec la barrette de silicium monocristallin en porte-à-faux mais séparée de celle-ci.

6. Dispositif de capteur MEMS (1) selon l'une quelconque des revendications précédentes, dans lequel le dispositif de capot (200) est collé à la structure semiconductrice multicouche (101) avec une structure de liaison de bague d'étanchéité eutectique à haute température (101C, 101E) pour former un vide dans une première cavité de capteur (207) qui contient le premier élément de transducteur inertiel (100).

7. Dispositif de capteur MEMS (1) selon l'une quelconque des revendications précédentes, dans lequel au moins la première surface d'espace de mesure (114D) du premier élément de masse étalon en semiconducteur monocristallin (101D) comporte une couche non uniforme de polymère déposé qui a été gravée de manière sélective pour former la première surface rugueuse.

8. Dispositif de capteur MEMS (1) selon la revendication 2 ou l'une quelconque des revendications 3 à 7 quand elles dépendent de la revendication 2, dans lequel au moins la deuxième surface d'espace de mesure (115E) du deuxième élément d'électrode conductrice (104D) comporte une couche non uniforme de polymère déposé qui a été gravée de manière sélective pour former la deuxième surface rugueuse.

9. Procédé de fabrication d'un transducteur comprenant les étapes suivantes :
fournir une structure de plaquette MEMS comprenant une première électrode semiconductrice et une première couche semiconductrice qui est formée sur la première électrode semiconductrice ;
graver de manière sélective (1005) la première couche semiconductrice pour former un premier élément de transducteur inertiel MEMS et des éléments de support de cadre environnants ;
appliquer (1006) un processus de gravure par libération structurelle pour libérer le premier élément de transducteur inertiel MEMS et pour exposer une première surface d'espace de mesure du premier élément de transducteur inertiel MEMS et une deuxième surface d'espace de mesure de la première électrode semiconductrice ;
appliquer un processus de gravure par abrasion de surface afin de rendre rugueuse l'une des première surface d'espace de mesure du premier élément de transducteur inertiel MEMS et deuxième surface d'espace de mesure de la première électrode semiconductrice, ou les deux, réduisant ainsi le frottement au démarrage entre le premier élément de transducteur inertiel MEMS et la première électrode semiconductrice ; et
fixer (1007) une première structure de plaquette de capot sur la structure de plaquette MEMS en utilisant un premier processus de liaison ;
**caractérisé en ce que** l'application du processus de gravure par abrasion de surface comprend le fait d'appliquer une gravure au plasma non homogène (113) qui grave des régions de frontière de grains cristallins dans le premier élément de transducteur inertiel MEMS ou la première électrode semiconductrice, ou les deux, plus vite que les régions non frontières dans le premier élément de transducteur inertiel MEMS ou la première électrode semiconductrice, ou les deux.

10. Procédé selon la revendication 9, dans lequel la fourniture de la structure de plaquette MEMS comprend le fait de former la première électrode semiconductrice sous forme d'électrode de silicium polycristallin sur laquelle la première couche semiconductrice est formée en tant que première couche semiconductrice monocristalline.

11. Procédé selon la revendication 9, dans lequel la fourniture de la structure de plaquette MEMS comprend le fait de former la première électrode semiconductrice sous forme d'électrode de silicium polycristallin sur laquelle la première couche semiconductrice est formée en tant que première couche semiconductrice polycristalline.

12. Procédé selon l'une quelconque des revendications 9 à 11, dans lequel la gravure sélective (1005) de la première couche semiconductrice comprend le fait de graver la première couche semiconductrice avec un processus de gravure profonde par ions réactifs pour former le premier élément de transducteur inertiel MEMS sous la forme d'un élément de transducteur de masse étalon à grand rapport d'aspect.

13. Procédé selon la revendication 12, dans lequel l'élément de transducteur de masse étalon à grand rapport d'aspect comprend un capteur à accéléromètre d'axe z.

14. Procédé selon l'une quelconque des revendications 9 à 13, dans lequel l'application (1006) du processus de gravure par libération structurelle comprend le fait d'appliquer une gravure par libération de vapeur afin de supprimer une couche diélectrique sacrificielle formée entre l'électrode semiconductrice et la première couche semiconductrice.
